(19) Europäisches Patentamt
European Patent Office
Office européen des brevets

(11) EP 4 530 277 A1

(12) EUROPÄISCHE PATENTANMELDUNG

(43) Veröffentlichungstag:
02.04.2025 Patentblatt 2025/14

(21) Anmeldenummer: 23199663.8

(22) Anmeldetag: 26.09.2023

(51) Internationale Patentklassifikation (IPC):
C04B 37/02 (2006.01)    H01L 23/373 (2006.01)
H05K 1/03 (2006.01)

(52) Gemeinsame Patentklassifikation (CPC):
C04B 37/021; H01L 21/4803; H01L 21/4871;
H01L 23/3735; H05K 1/0306; C04B 2237/343;
C04B 2237/366; C04B 2237/368; C04B 2237/402;
C04B 2237/407; C04B 2237/80; C04B 2237/84;
C04B 2237/86

(84) Benannte Vertragsstaaten:
AL AT BE BG CH CY CZ DE DK EE ES FI FR GB
GR HR HU IE IS IT LI LT LU LV MC ME MK MT NL
NO PL PT RO RS SE SI SK SM TR
Benannte Erstreckungsstaaten:
BA
Benannte Validierungsstaaten:
KH MA MD TN

(71) Anmelder: Heraeus Electronics GmbH & Co. KG
63450 Hanau (DE)

(72) Erfinder:
• THOMAS, Sven
  63450 Hanau (DE)

• SCHNEE, Daniel
  63450 Hanau (DE)
• MIRIC, Anton-Zoran
  63450 Hanau (DE)
• Der weitere Erfinder hat auf sein Recht
  verzichtet, als solcher bekannt gemacht zu
  werden.

(74) Vertreter: Heraeus IP
Heraeus Business Solutions GmbH
Intellectual Property
Heraeusstraße 12-14
63450 Hanau (DE)

(54) METALLISIERTES KERAMIKSUBSTRAT FÜR NIEDERINDUKTIVES LEISTUNGSMODUL UND VERFAHREN ZU DESSEN HERSTELLUNG

(57) Die vorliegende Erfindung betrifft ein metallisiertes Keramiksubstrat, umfassend:
ein Keramiksubstrat, das eine Vorderseite, eine Rückseite und Seitenflächen, die die Vorderseite und Rückseite miteinander verbinden, umfasst, wobei die Vorderseite und Rückseite jeweils zwei Längskanten und zwei Querkanten aufweisen,
eine Vorderseitenmetallisierung, die stoffschlüssig mit der Vorderseite des Keramiksubstrats verbunden ist und an jeder der Längskanten, jedoch keiner der Querkanten der Vorderseite des Keramiksubstrats übersteht,
eine Rückseitenmetallisierung, die stoffschlüssig mit der Rückseite des Keramiksubstrats verbunden ist und an jeder der Längskanten, jedoch keiner der Querkanten der Rückseite des Keramiksubstrats übersteht,
wobei die metallischen Längskantenüberstände der Vorderseite und der Rückseite stoffschlüssig miteinander oder mit einem oder mehreren metallischen Verbindungskörpern, die zwischen den metallischen Längskantenkantenüberständen positioniert sind, verbunden sind, so dass die Vorderseitenmetallisierung und Rückseitenmetallisierung des metallisierten Keramiksubstrats elektrisch leitend miteinander verbunden sind.

Figur 5

EP 4 530 277 A1

**Beschreibung**

Die vorliegende Erfindung betrifft ein metallisiertes Keramiksubstrat, das zur Verwendung in einem niederinduktiven Leistungsmodul geeignet ist, und ein Verfahren zur Herstellung eines solchen metallisierten Keramiksubstrats.

In der Leistungselektronik müssen Leiterplatten als Träger von Leistungsbauteilen wie MOSFETs für hohe Ströme ausgelegt sein und Verlustwärme schnell abführen können.

Da keramische Materialien wie Aluminiumoxid, Aluminiumnitrid und Siliziumnitrid gegenüber Polymeren, die für die Herstellung herkömmlicher Leiterplatten verwendet werden, eine wesentlich höhere Wärmeleitfähigkeit aufweisen, werden in Leistungsmodulen häufig keramische Schaltungsträger verwendet.

Ein keramischer Schaltungsträger enthält ein Keramiksubstrat, das beidseitig mit einer Metallschicht versehen ist (d.h. ein metallisiertes Keramiksubstrat, das eine Vorderseitenmetallisierung und Rückseitenmetallisierung aufweist). Auf einer dieser Metallschichten sind im finalen Modul die Halbleiterbauelemente aufgebracht, während die Metallschicht auf der gegenüberliegenden Seite des Keramiksubstrats thermisch leitend mit einem Kühlkörper verbunden ist. Durch das Keramiksubstrat sind die Metallschichten elektrisch isoliert voneinander.

Die die Halbleiterbauelemente tragende Metallschicht ist strukturiert (z.B. durch ein Ätzen), während die mit dem Kühlkörper thermisch verbundene Metallschicht üblicherweise keine Strukturierung aufweist. Die unstrukturierte Metallschicht wird beispielsweise stoffschlüssig mit einer Bodenplatte (z.B. eine Kupferbodenplatte) verbunden, die wiederum mit einem Kühlkörper verbunden wird oder die unstrukturierte Seite wird über ein zusätzliches wärmeleitendes Material wie z.B. eine Wärmeleitpaste mit dem Kühlkörper thermisch verbunden.

Die dem Fachmann bekannte Herstellung eines als keramische Leiterplatte fungierenden metallisierten Keramiksubstrats erfolgt beispielsweise, indem die Vorder- und Rückseite des Keramiksubstrats jeweils mit einer Metallfolie (z.B. einer Kupfer- oder Aluminiumfolie) in Kontakt gebracht und stoffschlüssig verbunden werden. Das stoffschlüssige Verbinden der Metallfolien erfolgt beispielsweise über ein eutektisches Bonden oder ein Aktivlöten (englisch: *"active metal brazing",* AMB). Ist die Metallfolie eine Kupferfolie, so wird das eutektische Bonding auch als DCB- oder DBC-Verfahren bezeichnet (DCB: *"Direct Copper Bonding";* DBC: *"Direct Bonded Copper"*). Im Fall einer Aluminiumfolie wird beim eutektischen Bonding auch die Bezeichnung "DAB" (*"Direct Aluminum Bonding"*) verwendet.

Ein über ein DCB- oder AMB-Verfahren hergestelltes metallisiertes Keramiksubstrat wird gelegentlich auch als DCB-Substrat (alternativ: DBC-Substrat) oder AMB-Substrat bezeichnet.

Ein in der Leistungselektronik auftretendes Problem ist die Streuinduktivität (auch als parasitäre Induktivität bezeichnet), siehe z.B. R. Bayerer, "Streuinduktivität, ein Problem der Leistungselektronik", Beitrag im Tagungsband zur Konferenz "Bauelemente der Leistungselektronik und ihre Anwendungen", 2017, 7. ETG-Fachtagung. Beim Ausschalten eines Transistors kommt es zu einem Stromsprung, der durch die parasitären Induktivitäten eine Spannungsspitze verursacht. Diese Spannungsspitze kann den Halbleiter schädigen und macht eine Anpassung der Sperrspannung erforderlich, was wiederum zu weiteren Energieverlusten im Transistor führt. Im Leistungsmodul sind Streuinduktivitäten daher unerwünscht und sollten so gering wie möglich gehalten werden.

Unterschiedliche Komponenten eines Leistungsmoduls wie z.B. die Anschlüsse, die Verbindungsdrähte oder die auf dem Keramiksubstrat vorliegende metallische Leiterstruktur (in Form der strukturierten Metallschicht) tragen zur Streuinduktivität bei. Eine Übersicht findet sich beispielsweise in H.Ma et al., "Review of the designs in low inductance SiC half-bridge packaging", IET Power Electron., 2022, 15: 989-1003.

Es ist bekannt, dass sich in einem Leistungsmodul die Streuinduktivität reduzieren lässt, wenn die Vorderseitenmetallisierung und Rückseitenmetallisierung über metallgefüllte Bohrungen (Vias, Durchkontaktierungen) im Keramiksubstrat elektrisch leitend miteinander verbunden sind. Da die beiden Metallschichten nun nicht mehr elektrisch isoliert voneinander sind, wird die unstrukturierte Metallschicht beispielsweise mit einem weiteren DCB-Substrat und dieses weitere DCB-Substrat mit einem Kühlkörper verbunden, wobei das Keramiksubstrat des weiteren DCB-Substrats die Metallschichten des ersten DCB-Substrats von dem Kühlkörper elektrisch isoliert.

Leistungsmodule, die DCB-Substrate enthalten, in denen die Vorderseiten- und Rückseitenmetallisierung über Durchkontaktierungen im Keramiksubstrat miteinander verbunden sind, werden beispielsweise in den folgenden Publikationen beschrieben:

B. Mouawad, J. Li, A. Castellazzi, C. M. Johnson, T. Erlbacher and P. Friedrichs, "Low inductance 2.5 kV packaging technology for SiC switches" CIPS 2016; 9th International Conference on Integrated Power Electronics Systems, Nürnberg, Deutschland, 2016, pp. 1-6

B. Mouawad, J. Li, A. Castellazzi, P. Friedrichs and C. M. Johnson, "Low parasitic inductance multi-chip SiC devices packaging technology", 2016, 18th European Conference on Power Electronics and Applications (EPE'16 ECCE Europe), Karlsruhe, Deutschland, doi: 10.1109/EPE.2016.7695571;

B. Mouawad, J. Li, A. Castellazzi and C. M. Johnson, "On the reliability of stacked metallized ceramic substrates under thermal cycling", CIPS 2018; 10th International Conference on Integrated Power Electronics Systems, Stuttgart, Deutschland, 2018, pp.

1-6;
C. Marczok, A. Meyer, "Direct Cooled Low Inductive SiC Mold Module", Power Electronics Europe, 2019, Issue 3, S. 19-20,
US 2017/194200 A1,
US 2018/286745 A1.

Das Anbringen von metallgefüllten Bohrungen ist aufwändig und daher nachteilig für die Effizienz des Herstellungsverfahrens.

T. Huber and A. Kleimaier, "Novel SiC Module Design - Optimised for Low Switching Losses, Efficient Cooling Path and Low Inductance", IPS 2018; 10th International Conference on Integrated Power Electronics Systems, Stuttgart, Germany, 2018, S. 1-6, beschreiben ein Leistungsmodul, das ein DCB-Substrat enthält, in dem die Metallschichten der Vorder- und Rückseite des Keramiksubstrats über einen aufgelöteten Metallbügel elektrisch leitend miteinander verbunden werden. Um eine möglichst gute und effiziente Verbindung der unstrukturierten Metallschicht des DCB-Substrats mit einer weiteren Schicht (wie z.B. einer Kupferbodenplatte), über die wiederum die thermische Verbindung zum Kühlkörper hergestellt wird, zu realisieren, wäre es vorteilhaft, wenn die Planarität der unstrukturierten Metallschicht möglichst über ihre gesamte Fläche gewährleistet ist. Durch den hervorstehenden Metallbügel reduziert sich jedoch die für die Verbindung zum Kühlkörper zur Verfügung stehende planare Metallfläche. Außerdem steht auf der gegenüberliegenden Metallschicht eine geringere Fläche für das Aufbringen von Halbleiterbauelementen zur Verfügung. Weiterhin wird eine zusätzliche elektrisch isolierende Schicht benötigt, um das Substrat gegenüber dem Kühlkörper zu isolieren, wobei dies mit einer Isolierfolie erfolgt.

DE 10 2013 113 734 A1 beschreibt ein Verfahren zur Herstellung eines metallisierten Keramiksubstrats, wobei (i) eine erste und zweite Metallschicht und das Keramiksubstrat übereinander gestapelt werden, und zwar derart, dass die freien Randabschnitte der ersten und zweiten Metallschicht jeweils randseitig am Keramiksubstrat überstehen, (ii) die überstehenden Randabschnitte direkt miteinander verbunden werden, so dass ein gasdicht verschlossener Metallbehälter vorliegt und (iii) durch ein heißisostatisches Pressen die Metallschichten und das Keramiksubstrat miteinander verbunden werden.

Eine Aufgabe der vorliegenden Erfindung liegt in der Bereitstellung eines metallisierten Keramiksubstrats (wie z.B. eines DCB- oder AMB-Substrats), das durch ein effizientes Herstellungsverfahren erhältlich ist. Das metallisierte Keramiksubstrat sollte eine gute thermische Anbindung an einen Kühlkörper ermöglichen und für die Verwendung in niederinduktiven Leistungsmodulen geeignet sein.

Gelöst wird die Aufgabe durch ein erstes erfindungsgemäßes Verfahren zur Herstellung eines metallisierten Keramiksubstrats, das eine Vorderseitenmetallisierung und eine Rückseitenmetallisierung aufweist, die elektrisch leitend miteinander verbunden sind, wobei das Verfahren folgende Schritte umfasst:

Bereitstellung eines Keramiksubstrats, das eine Vorderseite, eine Rückseite und Seitenflächen, die die Vorder- und Rückseite miteinander verbinden, umfasst, wobei die Vorderseite und die Rückseite jeweils zwei Längskanten und zwei Querkanten aufweisen,

in Kontakt bringen der Vorderseite des Keramiksubstrats mit einer ersten Metallfolie, wobei die erste Metallfolie an jeder der Längskanten der Vorderseite des Keramiksubstrats übersteht, so dass an jeder der Längskanten der Vorderseite des Keramiksubstrats ein metallischer Längskantenüberstand vorliegt,

in Kontakt bringen der Rückseite des Keramiksubstrats mit einer zweiten Metallfolie, wobei die zweite Metallfolie an jeder der Längskanten der Rückseite des Keramiksubstrats übersteht, so dass an jeder der Längskanten der Rückseite des Keramiksubstrats ein metallischer Längskantenüberstand vorliegt,

wobei an zwei der Seitenflächen des Keramiksubstrats sich die metallischen Längskantenüberstände der Vorderseite und der Rückseite des Keramiksubstrats gegenüberstehen,

stoffschlüssiges Verbinden der Vorderseite des Keramiksubstrats mit der ersten Metallfolie, so dass eine Vorderseitenmetallisierung erhalten wird,

stoffschlüssiges Verbinden der Rückseite des Keramiksubstrats mit der zweiten Metallfolie, so dass eine Rückseitenmetallisierung erhalten wird,

stoffschlüssiges Verbinden der sich gegenüberstehenden metallischen Längskantenüberstände miteinander oder mit einem oder mehreren metallischen Verbindungskörpern, die zwischen den sich gegenüberstehenden metallischen Längskantenkantenüberständen positioniert sind, so dass ein metallisiertes Keramiksubstrat erhalten wird, dessen Vorderseitenmetallisierung und Rückseitenmetallisierung über zwei Seitenflächen des Keramiksubstrats elektrisch leitend miteinander verbunden sind.

In dem ersten erfindungsgemäßen Verfahren werden keine Durchkontaktierungen im Keramiksubstrat benötigt, um die Metallschichten auf der Vorder- und Rückseite des Keramiksubstrats elektrisch leitend miteinander zu verbinden. Wie in den herkömmlichen Verfahren zur Metallisierung eines Keramiksubstrats werden auch in dem erfindungsgemäßen Verfahren die Vorder- und Rückseite des Keramiksubstrats jeweils stoffschlüssig mit einer Metallfolie (z.B. eine Kupfer- oder Aluminiumfolie) verbunden (z.B. durch ein DCB- oder DAB-Verfahren oder ein Aktivlöten). Dabei sind die Metallfolien in ihren Abmessungen so ausgelegt, dass sie an den Längskanten der Vorderseite und Rückseite des Keramiksubstrats überstehen. An jeder der Längskanten der Vorder- und Rückseite liegt ein metallischer Längskantenüberstand vor, so dass zwei Seitenflächen des Keramiksubstrats sich die metallischen Längskantenüberstände der Vorder- und Rückseite gegenüberstehen.

Da die sich gegenüberstehenden Längskantenüberstände miteinander oder mit einem zwischen den Längskantenüberständen positionierten metallischen Verbindungskörper, nicht jedoch mit einem auf der Oberfläche der Metallisierungen hervorstehenden Verbindungskörper (wie z.B. einem aufgelöteten Metallbügel) verbunden werden, kann eine Reduzierung der planaren Metalloberfläche vermieden werden. Dies ermöglicht eine gute und effiziente Verbindung des metallisierten Keramiksubstrats mit einer weiteren Metallschicht, über die wiederum die thermische Verbindung zum Kühlkörper hergestellt wird.

Da außerdem die Vorderseiten- und Rückseitenmetallisierungen über zwei Seitenflächen des Keramiksubstrats elektrisch leitend miteinander verbunden sind, ist das mit dem ersten erfindungsgemäßen Verfahren erhaltene metallisierte Keramiksubstrat sehr gut für die Herstellung niederinduktiver Leistungsmodule geeignet.

Alternativ wird die oben genannte Aufgabe gelöst durch ein zweites erfindungsgemäßes Verfahren zur Herstellung eines metallisierten Keramiksubstrats, das eine Vorderseitenmetallisierung und eine Rückseitenmetallisierung aufweist, die elektrisch leitend miteinander verbunden sind, wobei das Verfahren folgende Schritte umfasst:

Bereitstellung eines Keramiksubstrats, das eine Vorderseite, eine Rückseite und Seitenflächen, die die Vorder- und Rückseite miteinander verbinden, umfasst, wobei die Vorderseite und die Rückseite jeweils zwei Längskanten und zwei Querkanten aufweisen,

in Kontakt bringen der Vorderseite des Keramiksubstrats mit einer Metallfolie, wobei die Metallfolie an jeder der Längskanten der Vorderseite des Keramiksubstrats übersteht, so dass an jeder der Längskanten der Vorderseite des Keramiksubstrats ein metallischer Längskantenüberstand vorliegt und wobei sich die metallischen Längskantenüberstände bis zur Rückseite des Keramiksubstrats erstrecken, so dass die Metallfolie auch mit der Rückseite des Keramiksubstrats in Kontakt ist,

stoffschlüssiges Verbinden der Metallfolie mit der Vorder- und Rückseite des Keramiksubstrats unter Ausbildung einer Vorderseiten- und Rückseitenmetallisierung, so dass ein metallisiertes Keramiksubstrat erhalten wird, dessen Vorderseitenmetallisierung und Rückseitenmetallisierung über zwei Seitenflächen des Keramiksubstrats elektrisch leitend miteinander verbunden sind.

In diesem zweiten erfindungsgemäßen Verfahren ist die Metallfolie ebenfalls so ausgelegt, dass sie an den Längskanten der Vorderseite des Keramiksubstrats übersteht. Die Längskantenüberstände erstrecken sich bis zur Rückseite des Keramiksubstrats. Die Metallfolie wird sowohl mit der Vorderseite wie auch mit der Rückseite des Keramiksubstrats stoffschlüssig verbunden. Dies ermöglicht es, mit nur einer Metallfolie die Vorder- und Rückseite des Keramiksubstrats zu metallisieren und die Vorderseiten- und Rückseitenmetallisierung elektrisch leitend miteinander zu verbinden. Ein Verbinden der Metallfolien über einen separaten Verbindungskörpers (wie z.B. einen aufgelöteten Metallbügel), der auf der Oberfläche der Metallfolie hervorsteht und daher die planare Metalloberfläche verringert, ist nicht erforderlich.

Da die Vorderseiten- und Rückseitenmetallisierungen über zwei Seitenflächen des Keramiksubstrats elektrisch leitend miteinander verbunden sind, ist auch das mit dem zweiten erfindungsgemäßen Verfahren erhaltene metallisierte Keramiksubstrat sehr gut für die Herstellung niederinduktiver Leistungsmodule geeignet.

Sofern nicht gesondert spezifiziert, betreffen die nachfolgenden Ausführungen sowohl das erste erfindungsgemäße Verfahren wie auch das zweite erfindungsgemäße Verfahren.

Keramiksubstrate, die für die Herstellung von Leistungsmodulen geeignet sind, sind dem Fachmann bekannt und kommerziell erhältlich.

Das Keramiksubstrat weist eine Vorderseite, eine Rückseite und Seitenflächen, die die Vorder- und Rückseite miteinander verbinden, auf. Die Vorderseite und Rückseite weisen jeweils zwei Längskanten und zwei Querkanten auf.

Wie nachfolgend noch eingehender beschrieben, kann das bereitgestellte und zu metallisierende Keramiksubstrat ein Keramiksubstrat für Mehrfachnutzen (nachfolgend auch als Mehrfachnutzen-Keramiksubstrat bezeichnet) oder ein Keramiksubstrat für Einfachnutzen (Einfachnutzen-Keramiksubstrat) sein. Sofern es sich bei dem Keramiksubstrat um ein Mehrfachnutzen-Keramiksubstrat handelt, wird dieses in einem späteren Schritt des Verfahrens vereinzelt (z.B. durch ein Brechen an Sollbruchstellen), so dass zwei oder mehr metallisierte Einfachnutzen-Keramiksubstrate erhalten werden.

In einem Einfachnutzen-Keramiksubstrat weisen die Vorder- und Rückseite beispielsweise eine eher quadratische Form auf. Beispielsweise gilt:

$$0,6 \leq L_{\text{LK-EN}}/L_{\text{QK-EN}} \leq 1,5$$

wobei

$L_{\text{LK-EN}}$ die Länge einer Längskante der Vorder- oder Rückseite des Einfachnutzen-Keramiksubstrats ist und

$L_{\text{QK-EN}}$ die Länge einer Querkante der Vorder- oder Rückseite des Einfachnutzen-Keramiksubstrats ist.

In einem Mehrfachnutzen-Keramiksubstrat können die Vorder- und Rückseite beispielsweise eine nahezu quadratische bis längliche Form aufweisen. Beispielsweise gilt:

$$0{,}6 \leq L_{LK\text{-}MN}/L_{QK\text{-}MN} \leq 15$$

wobei

$L_{LK\text{-}MN}$ die Länge einer Längskante der Vorder- oder Rückseite des Mehrfachnutzen-Keramiksubstrats ist und
$L_{QK\text{-}MN}$ die Länge einer Querkante der Vorder- oder Rückseite des Mehrfachnutzen-Keramiksubstrats ist.

In einer weiteren beispielhaften Ausführungsform gilt:

$$4 \leq L_{LK\text{-}MN}/L_{QK\text{-}MN} \leq 15$$

Für die nach der Vereinzelung in einem späteren Verfahrensschritt erhaltenen metallisierten Keramikeinzelsubstrate gilt beispielsweise wieder die oben genannte Beziehung, d.h. $0{,}6 \leq L_{LK\text{-}EN}/L_{QK\text{-}EN} \leq 1{,}5$.

Die beiden Längskanten der Vorderseite verlaufen bevorzugt im Wesentlichen parallel zueinander (180° +/- 10°). Die Längs- und Querkanten verlaufen beispielsweise im Wesentlichen senkrecht zueinander (90° +/- 10°). Die Längs- und Querkanten der Vorderseite treffen sich in den Ecken, wobei es sich bei den Ecken auch um abgeschrägte oder abgerundete Ecken handeln kann.

Auch für die Rückseite des Keramiksubstrats gilt, dass die beiden Längskanten bevorzugt im Wesentlichen parallel zueinander (180° +/- 10°) verlaufen und/oder die Längs- und Querkanten bevorzugt im Wesentlichen senkrecht zueinander (90° +/- 10°) verlaufen.

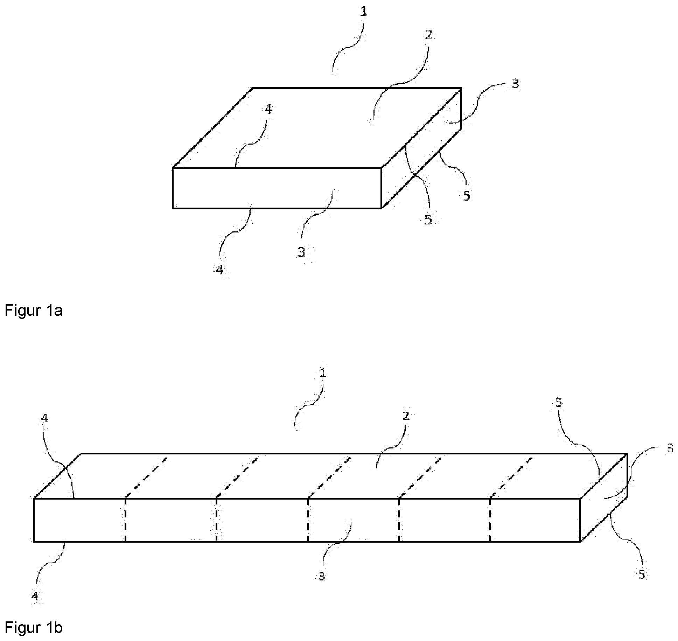

Figur 1a zeigt eine schematische Darstellung eines beispielhaften Einfachnutzen-Keramiksubstrat und Figur 1 b zeigt eine schematische Darstellung eines beispielhaften Mehrfachnutzen-Keramiksubstrats, das in dem Verfahren der vorliegenden Erfindung metallisiert werden kann. Die Keramiksubstrate 1 weisen jeweils eine Vorderseite 2, eine Rückseite und Seitenflächen 3, die die Vorderseite 2 und Rückseite miteinander verbinden, auf. Die Vorderseite 2 und die Rückseite sind jeweils durch Längskanten 4 und Querkanten 5 begrenzt. Die gestrichelten Linien in Figur 1b deuten Sollbruchstellen für das Separieren des Mehrfachnutzen-Keramiksubstrats in mehrere Einfachnutzen-Keramiksubstrate an. Es ist nicht erforderlich, dass die Sollbruchstellen bereits in dem noch zu metallisierenden Keramiksubstrat vorliegen. Beispielsweise werden die Sollbruchstellen erst nach der Metallisierung des Keramiksubstrats angebracht. Dazu wird beispielsweise die Metallisierung in den entsprechenden Bereichen entfernt (z.B. durch Ätzen) und in den freigelegten Bereichen des Keramiksubstrats werden Sollbruchstellen generiert.

Das Keramiksubstrat enthält beispielsweise Aluminiumoxid, Aluminiumnitrid oder Siliziumnitrid.
Beispielsweise enthält das Keramiksubstrat Aluminiumoxid, Aluminiumnitrid oder Siliziumnitrid in einem Anteil von mindestens 70 Gew%.
Beispielsweise enthält das Keramiksubstrat neben Aluminiumoxid noch ein Zirkonoxid, z.B. in einem Anteil von bis zu 30 Gew% (beispielsweise 1-30 Gew%). Das Zirkonoxid ist beispielsweise ein mit Yttrium, Magnesium und/oder Kalzium dotiertes Zirkonoxid.
Das Keramiksubstrat weist beispielsweise eine Dicke im Bereich von 0,1 mm bis 1,0 mm auf.
In dem ersten erfindungsgemäßen Verfahren ist die erste Metallfolie so bemessen, dass sie an jeder der Längskanten der Vorderseite des Keramiksubstrats übersteht und ist die zweite Metallfolie so bemessen, dass sie an jeder der Längskanten der Rückseite des Keramiksubstrats übersteht.
Somit liegt in dem ersten erfindungsgemäßen Verfahren an jeder der Längskanten der Vorderund Rückseite des Keramiksubstrats ein metallischer Längskantenüberstand vor und an zwei der Seitenflächen des Keramiksubstrats stehen sich die metallischen Längskantenüberstände der Vorder- und Rückseite des Keramiksubstrats gegenüber.
Die erste Metallfolie und die zweite Metallfolie sind beispielsweise jeweils eine Kupfer- oder Aluminiumfolie.
In einer bevorzugten Ausführungsform sind die erste Metallfolie und die zweite Metallfolie jeweils eine Kupferfolie.
Die erste und zweite Metallfolie weisen beispielsweise eine Dicke im Bereich von 0,05 mm bis 1,5 mm, bevorzugter 0,2 mm bis 0,6 mm auf.
Sofern die erste oder zweite Metallfolie eine Kupferfolie ist, weist diese beispielsweise einen Kupfergehalt von mindestens 97 Gew% auf.
Sofern die erste oder zweite Metallfolie eine Aluminiumfolie ist, weist diese beispielsweise einen Aluminiumgehalt von mindestens 97 Gew% auf.
Metallfolien, die die oben genannten Eigenschaften aufweisen, sind dem Fachmann bekannt und kommerziell erhältlich.
Die Vorderseite des Keramiksubstrats wird stoffschlüssig mit der ersten Metallfolie verbunden, so dass eine Vorderseitenmetallisierung erhalten wird und die Rückseite des Keramiksubstrats wird stoffschlüssig mit der zweiten Metallfolie verbunden, so dass eine Rückseitenmetallisierung erhalten wird.
Die sich an zwei der Seitenflächen gegenüberstehenden metallischen Längskantenüberstände der Vorder- und Rückseite des Keramiksubstrats werden miteinander oder mit einem oder mehreren metallischen Verbindungskörpern, die zwischen den sich gegenüberstehenden metallischen Längskantenkantenüberständen positioniert sind, stoffschlüssig verbunden.

Die Reihenfolge der oben beschriebenen Verfahrensschritte kann variiert werden.

Beispielsweise können zunächst die Vorderseite des Keramiksubstrats mit der ersten Metallfolie und die Rückseite des Keramiksubstrats mit der zweiten Metallfolie in Kontakt gebracht werden und anschließend erfolgt das stoffschlüssige Verbinden der Metallfolien mit der Vorder- und Rückseite des Keramiksubstrats. Alternativ kann beispielsweise zunächst die erste Metallfolie mit der Vorderseite (oder die zweite Metallfolie mit der Rückseite) des Keramiksubstrats in Kontakt gebracht und stoffschlüssig verbunden werden und anschließend erfolgt das in Kontakt bringen und stoffschlüssige Verbinden der zweiten Metallfolie mit der Rückseite (oder der ersten Metallfolie mit der Vorderseite) des Keramiksubstrats.

Das stoffschlüssige Verbinden der sich an zwei der Seitenflächen des Keramiksubstrats gegenüberstehenden metallischen Längskantenüberstände miteinander oder mit einem oder mehreren zwischen den metallischen Längskantenüberständen positionierten metallischen Verbindungskörpern kann beispielsweise zeitlich überlappend mit dem stoffschlüssigen Verbinden der ersten und zweiten Metallfolie mit der Vorder- und Rückseite des Keramiksubstrats erfolgen. Alternativ können beispielsweise zunächst die erste und zweite Metallfolie mit der Vorderseite und Rückseite des Keramiksubstrat stoffschlüssig verbunden werden und anschließend werden die sich gegenüberstehenden metallischen Längskantenüberstände miteinander oder mit einem oder mehreren zwischen den metallischen Längskantenüberständen positionierten metallischen Verbindungskörper stoffschlüssig verbunden.

In einer beispielhaften Ausführungsform des ersten erfindungsgemäßen Verfahrens steht die erste Metallfolie an keiner der Querkanten der Vorderseite des Keramiksubstrats über und steht die zweite Metallfolie an keiner der Querkanten der Rückseite des Keramiksubstrats über. Somit liegt in dieser beispielhaften Ausführungsform an keiner der Querkanten der Vorderseite des Keramiksubstrats und an keiner der Querkanten der Rückseite des Keramiksubstrats ein metallischer Querkantenüberstand vor.

Alternativ ist es in dem ersten erfindungsgemäßen Verfahren beispielsweise möglich, dass die erste Metallfolie an mindestens einer der Querkanten der Vorderseite des Keramiksubstrats übersteht und/oder die zweite Metallfolie an mindestens einer der Querkanten der Rückseite des Keramiksubstrats übersteht, so dass an mindestens einer Querkante der Vorderseite und/oder mindestens einer Querkante der Rückseite ein metallischer Querkantenüberstand vorliegt, jedoch wird kein metallischer Querkantenüberstand verwendet, um die Vorderseitenmetallisierung und Rückseitenmetallisierung elektrisch leitend miteinander zu verbinden.

Beispielsweise stehen in dem ersten erfindungsgemäßen Verfahren die metallischen Längskantenüberstände jeweils um nicht mehr als 5 mm, bevorzugter nicht mehr als 3 mm an den Längskanten über. Die Länge eines metallischen Längskantenüberstands wird bestimmt in einer Richtung senkrecht zur Längskante.

Das stoffschlüssige Verbinden der ersten Metallfolie mit der Vorderseite des Keramiksubstrats und der zweiten Metallfolie mit der Rückseite des Keramiksubstrats kann über Verbindungsverfahren erfolgen, die dem Fachmann bekannt sind.

Beispielsweise werden die erste Metallfolie und die zweite Metallfolie durch ein eutektisches Bonden, insbesondere ein Direct-Copper-Bonding (DCB), oder ein Löten, insbesondere ein Aktivlöten, stoffschlüssig mit der Vorder- und Rückseite des Keramiksubstrats verbunden.

Wie dem Fachmann bekannt ist, wird beim eutektischen Bonden die Metallfolie einer Vorbehandlung (z.B. einer oberflächlichen Oxidation) unterzogen, so dass auf der Oberfläche der Metallfolie eine Zusammensetzung vorliegt, die gegenüber dem Metall (z.B. Kupfer oder Aluminium) einen geringeren Schmelzpunkt (Eutektikum) aufweist. Das eutektische Bonden wird bei einer Temperatur durchgeführt, die oberhalb der Schmelztemperatur des Eutektikums, aber unterhalb der Schmelztemperatur des Metalls liegt. Das geschmolzene Eutektikum unterstützt das stoffschlüssige Verbinden der Metallfolie mit dem Verbindungspartner, z.B. dem Keramiksubstrat oder einem weiteren Metallkörper. Beim Direct-Copper-Bonding (DCB) ist die Metallfolie eine Kupferfolie.

Beim DCB-Verfahren wird beispielsweise ausgenutzt, dass im Kupfer-Sauerstoff-Phasendiagramm ein Eutektikum vorliegt, das bei etwa 1065 °C schmilzt und somit einen um etwa 20 °C niedrigeren Schmelzpunkt besitzt als Kupfer. Zuerst wird die Kupferfolie oberflächlich voroxidiert und anschließend über das flüssige Eutektikum stoffschlüssig mit dem Verbindungspartner (z.B. dem Keramiksubstrat) verbunden.

Sofern das Keramiksubstrat ein Aluminiumnitrid oder Siliziumnitrid enthält, kann es vorteilhaft sein, das Keramiksubstrat an seiner Oberfläche zu oxidieren (d.h. das Aluminiumnitrid oder Siliziumnitrid an der Oberfläche des Keramiksubstrats zumindest teilweise in ein Aluminiumoxid oder Siliziumoxid zu überführen) und anschließend die Metallfolie stoffschlüssig mit der Vorder- oder Rückseite des Keramiksubstrats zu verbinden.

Das DCB-Verfahren wird beispielsweise beschrieben in US 3,744,120, DE 23 19 854 und J.F. Burgess et al., "The direct bonding of metals to ceramics and application in electronics", Electrocomponent Science and Technology, 1976, Band 2, S. 233-240.

Beispielsweise werden beim stoffschlüssigen Verbinden durch ein Direct-Copper-Bonding die erste Metallfolie (die eine Kupferfolie ist) und die zweite Metallfolie (die ebenfalls eine Kupferfolie ist) jeweils oberflächlich oxidiert, so dass sich auf den Oberflächen der ersten und zweiten Metallfolie jeweils eine Kupferoxidschicht bildet, und auf eine Temperatur< 1083°C (z.B. eine Temperatur im Bereich von 1065-1080°C) erwärmt.

Beim Aktivlöten wird beispielsweise bei einer Temperatur von etwa 600-1000°C eine Verbindung zwischen der Metallfolie und dem Keramiksubstrat unter Verwendung eines Aktivlots hergestellt. Aktivlote sind aufgrund ihrer Legierungszusammensetzung in der Lage, nichtmetallische, anorganische Werkstoffe wie z.B. Keramiksubstrate zu benetzen. Neben einer Hauptkomponente wie z.B. Kupfer, Silber und/oder Gold enthalten Aktivlote auch ein oder mehrere Aktivmetalle wie z.B. Hf, Ti, Zr, Nb, V oder Ce, die mit dem Verbindungspartner (z.B. dem Keramiksubstrat) reagieren können.

In dem ersten erfindungsgemäßen Verfahren werden die sich an zwei der Seitenflächen des Keramiksubstrats gegenüberstehenden metallischen Längskantenüberstände miteinander oder mit einem oder mehreren metallischen Verbindungskörpern, die zwischen den sich gegenüberstehenden metallischen Längskantenkantenüberständen positioniert sind, stoffschlüssig verbunden, so dass ein metallisiertes Keramiksubstrat erhalten wird, dessen Vorderseitenmetallisierung und Rückseitenmetallisierung über zwei Seitenflächen des Keramiksubstrats elektrisch leitend miteinander verbunden sind.

Das stoffschlüssige Verbinden der sich gegenüberstehenden metallischen Längskantenüberstände miteinander oder mit einem oder mehreren metallischen Verbindungskörpern erfolgt beispielsweise durch ein Löten, ein Sintern, ein Kleben unter Verwendung eines elektrisch leitfähigen Klebstoffs oder ein eutektisches Bonden, insbesondere ein Direct-Copper-Bonding (DCB), oder mittels eines mechanischen Verfahrens (z.B. durch ein Fügen unter hohem Druck).

Für das Löten kann ein Weichlot oder alternativ auch ein Hartlot verwendet werden. Ein Aktivlot kann ebenfalls verwendet werden.

Für das Sintern kann eine dem Fachmann bekannte Sinterpaste, z.B. eine Silber oder Kupfer basierte Sinterpaste verwendet werden.

Hinsichtlich des eutektischen Bonden kann auf die obigen Ausführungen verwiesen werden.

Elektrisch leitfähige Klebstoffe, mit denen sich Metalle stoffschlüssig und elektrisch leitend miteinander verbinden lassen, sind dem Fachmann bekannt.

Das stoffschlüssige Verbinden der sich gegenüberstehenden metallischen Längskantenüberstände miteinander oder mit dem metallischen Verbindungskörper durch ein mechanisches Verfahren kann zum Beispiel unter Aufbringung von Druck auf zu verbindenden Metallbereiche, optional in Kombination mit erhöhter Temperatur und/oder Ultraschall erfolgen.

Der metallische Verbindungskörper, mit dem die sich gegenüberstehenden Längskantenüberstände der Vorder- und Rückseite des Keramiksubstrats verbunden werden, ist beispielsweise drahtförmig oder bandförmig.

Beispielsweise enthält der metallische Verbindungskörper Kupfer oder Aluminium. Bevorzugt enthält der metallische Verbindungskörper mindestens 97 Gew% Kupfer oder mindestens 97 Gew% Aluminium.

In einer beispielhaften Ausführungsform ist der metallische Verbindungskörper ein Kupferdraht, ein Kupferbändchen, ein Aluminiumdraht oder ein Aluminiumbändchen.

Ist der metallische Verbindungskörper drahtförmig (z.B. ein Kupfer- oder Aluminiumdraht), so weist der Draht bevorzugt eine Dicke auf, die nicht größer ist als die Dicke des Keramiksubstrats. Ist der metallische Verbindungskörper bandförmig (z.B. ein Kupfer- oder Aluminiumbändchen), so weist das Band bevorzugt eine Bandbreite oder eine Banddicke auf, die nicht größer ist als die Dicke des Keramiksubstrats.

Beispielsweise ist der draht- oder bandförmige metallische Verbindungskörper zumindest abschnittsweise im Wesentlichen parallel (180° +/- 10°) zu einer der Seitenflächen positioniert.

Beispielsweise wird zumindest einer der metallischen Längskantenüberstände vor dem Verbinden mit dem an einer der Seitenflächen des Keramiksubstrats gegenüberstehenden metallischen Längskantenüberstand zumindest einmal entlang einer Faltkante gefaltet und der gefaltete metallische Längskantenüberstand mit dem gegenüberstehenden Längskantenüberstand verbunden. Die Faltkante verläuft beispielsweise im Wesentlichen parallel (180° +/- 10°) zu der Längskante, an der der gefaltete metallische Längskantenüberstand übersteht.

Beispielsweise ist der gefaltete metallische Längskantenüberstand während des stoffschlüssigen Verbindens mit dem gegenüberliegenden metallischen Längskantenüberstand in Kontakt mit einer Seitenfläche des Keramiksubstrats. Optional kann der gefaltete metallische Längskantenüberstand nicht nur mit dem gegenüberliegenden metallischen Längskantenüberstand, sondern auch mit einer Seitenfläche des Keramiksubstrats stoffschlüssig verbunden werden.

Durch das stoffschlüssige Verbinden der sich gegenüberstehenden metallischen Längskantenüberstände miteinander oder mit einem oder mehreren metallischen Verbindungskörpern, die zwischen den sich gegenüberstehenden metallischen Längskantenüberständen positioniert sind, werden die Vorderseiten- und Rückseitenmetallisierung elektrisch leitend miteinander verbunden.

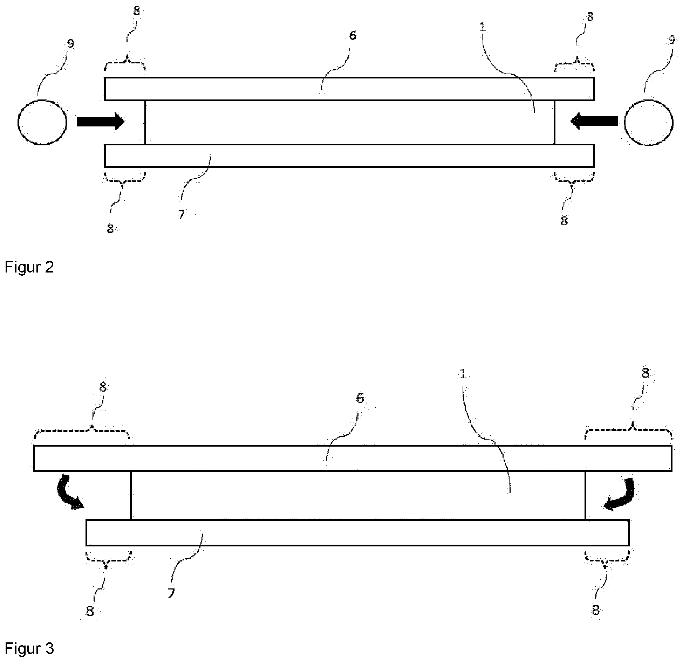

Figur 2 veranschaulicht das in Kontakt bringen des Keramiksubstrats mit einer ersten und zweiten Metallfolie, die jeweils an den Längskanten des Keramiksubstrats überstehen, und das Positionieren eines metallischen Verbindungskörpers zwischen sich gegenüberstehenden metallischen Längskantenüberständen. Eine erste Metallfolie 6 ist in Kontakt mit der Vorderseite des Keramiksubstrats 1 und steht an den Längskanten der Vorderseite über. Eine zweite Metallfolie 7 ist mit der Rückseite des Keramiksubstrats 1 in Kontakt und steht an den Längskanten der Rückseite über. Somit liegen an den Längskanten der Vorder- und Rückseite des Keramiksubstrats 1 metallische Längskantenüberstände 8 vor. Die Abmessungen der metallischen Längskantenüberstände 8 werden durch die gestrichelten geschweiften Klammern veranschaulicht. Ein drahtförmiger metallischer Verbindungskörper 9 wird jeweils zwischen sich gegenüberstehenden Längskantenüberständen 8 positioniert (in Figur 2 durch Pfeile veranschaulicht).

Durch stoffschlüssiges Verbinden der ersten Metallfolie 6 mit der Vorderseite des Keramiksubstrats 1, stoffschlüssiges Verbinden der zweiten Metallfolie 7 mit der Rückseite des Keramiksubstrats 1 und stoffschlüssiges Verbinden der metallischen Längskantenüberstände 8 mit den metallischen Verbindungskörpern 9 kann ein metallisiertes Keramiksubstrat erhalten werden, dessen Vorderseitenmetallisierung und Rückseitenmetallisierung über zwei Seitenflächen des Keramiksubstrats elektrisch leitend miteinander verbunden sind. Wie oben bereits erwähnt, kann die zeitliche Reihenfolge des stoffschlüssigen Verbindens variiert werden. Beispielsweise können zunächst die Metallfolien 6 und 7 stoffschlüssig mit dem Keramiksubstrat 1 verbunden werden und anschließend erfolgt das stoffschlüssige Verbinden der metallischen Längskantenüberstände 8 mit den metallischen Verbindungskörpern 9. Alternativ ist es beispielsweise auch möglich, dass alle stoffschlüssigen Verbindungen zeitlich überlappend ausgebildet werden.

Figur 3 veranschaulicht das in Kontakt bringen des Keramiksubstrats mit einer ersten und zweiten Metallfolie, die jeweils an den Längskanten des Keramiksubstrats überstehen, und das Verbinden der sich gegenüberstehenden metallischen Längskantenüberstände. Eine erste Metallfolie 6 ist in Kontakt mit der Vorderseite des Keramiksubstrats 1 und steht an den Längskanten der Vorderseite über. Eine zweite Metallfolie 7 ist mit der Rückseite des Keramiksubstrats 1 in Kontakt und steht an den Längskanten der Rückseite über. Somit liegen an den Längskanten der Vorder- und Rückseite des Keramiksubstrats 1 metallische Längskantenüberstände 8 vor. Die Abmessungen der metallischen Längskantenüberstände 8 werden durch die gestrichelten geschweiften Klammern veranschaulicht. Durch ein Falten der Längskantenüberstände 8 der Vorderseite in Richtung der Längskantenüberstände 8 der Rückseite (in Figur 3 durch Pfeile veranschaulicht) können die sich gegenüberstehenden Längskantenüberstände miteinander für ein stoffschlüssiges Verbinden in Kontakt gebracht werden. Durch stoffschlüssiges Verbinden der ersten Metallfolie 6 mit der Vorderseite des Keramiksubstrats 1, stoffschlüssiges Verbinden der zweiten Metallfolie 7 mit der Rückseite des Keramiksubstrats 1 und stoffschlüssiges Verbinden der metallischen Längskantenüberstände 8 miteinander kann ein metallisiertes Keramiksubstrat erhalten werden, dessen Vorderseitenmetallisierung und Rückseitenmetallisierung über zwei Seitenflächen des Keramiksubstrats elektrisch leitend miteinander verbunden sind. Wie oben bereits erwähnt, kann die zeitliche Reihenfolge des stoffschlüssigen Verbindens variiert werden. Beispielsweise können zunächst die Metallfolien 6 und 7 stoffschlüssig mit dem Keramiksubstrat 1 verbunden werden und anschließend werden die sich gegenüberstehenden metallischen Längskantenüberstände 8 durch ein Falten miteinander in Kontakt gebracht und stoffschlüssig verbunden. Alternativ ist es beispielsweise auch möglich, dass alle stoffschlüssigen Verbindungen zeitlich überlappend ausgebildet werden.

In dem zweiten erfindungsgemäßen Verfahren wird die Vorderseite des Keramiksubstrats mit einer Metallfolie in Kontakt gebracht, wobei die Metallfolie an jeder der Längskanten der Vorderseite des Keramiksubstrats übersteht, so dass an jeder der Längskanten der Vorderseite des Keramiksubstrats ein metallischer Längskantenüberstand vorliegt, wobei sich die metallischen Längskantenüberstände bis zur Rückseite des Keramiksubstrats erstrecken, so dass die Metallfolie auch mit der Rückseite des Keramiksubstrats in Kontakt ist.

Die Metallfolie ist beispielsweise eine Kupfer- oder Aluminiumfolie.

Die Metallfolie weist beispielsweise eine Dicke im Bereich von 0,05 mm bis 1,5 mm, bevorzugter 0,2 mm bis 0,6 mm auf.

Sofern die Metallfolie eine Kupferfolie ist, weist diese beispielsweise einen Kupfergehalt von mindestens 97 Gew% auf. Sofern die Metallfolie eine Aluminiumfolie ist, weist diese beispielsweise einen Aluminiumgehalt von mindestens 97 Gew% auf.

Die Metallfolie wird mit der Vorder- und Rückseite des Keramiksubstrats stoffschlüssig verbunden, so dass eine Vorderseiten- und Rückseitenmetallisierung ausgebildet und ein metallisiertes Keramiksubstrat erhalten wird, dessen Vorderseitenmetallisierung und Rückseitenmetallisierung über zwei Seitenflächen elektrisch leitend miteinander verbunden sind.

Das stoffschlüssige Verbinden der Metallfolie mit der Vorderseite und Rückseite des Keramiksubstrats kann über Verbindungsverfahren erfolgen, die dem Fachmann bekannt sind.

Beispielsweise wird die Metallfolie durch ein eutektisches Bonden, insbesondere ein Direct-Copper-Bonding (DCB), oder ein Löten, insbesondere ein Aktivlöten, stoffschlüssig mit der Vorder- und Rückseite des Keramiksubstrats verbunden.

Hinsichtlich weiterer Einzelheiten dieser Verfahren zum stoffschlüssigen Verbinden einer Metallfolie mit einem Keramiksubstrat kann auf die hinsichtlich des ersten erfindungsgemäßen Verfahrens gemachten Ausführungen verwiesen werden.

In dem zweiten erfindungsgemäßen Verfahren erstrecken sich die metallischen Längskantenüberstände der Vorderseite bis zur Rückseite des Keramiksubstrats, d.h. die metallischen Längskantenüberstände der Vorderseite werden mit der Rückseite des Keramiksubstrats in Kontakt gebracht. Die Längen der metallischen Längskantenüberstände können beispielsweise so gewählt werden, dass die metallischen Längskantenüberstände auf der Rückseite des Keramiksubstrats unmittelbar aneinander grenzen. Sofern die metallischen Längskantenüberstände auf der Rückseite des Keramiksubstrats ausreichend voneinander beabstandet sind, kann optional zwischen diesen Längskantenüberständen eine weitere Metallfolie mit der Rückseite des Keramiksubstrats in Kontakt gebracht und stoffschlüssig verbunden werden. Diese weitere Metallfolie ist beispielsweise eine Kupfer- oder Aluminiumfolie. Hinsichtlich des stoffschlüssigen Verbindens kann auf die obigen Ausführungen verwiesen werden. Bevorzugt steht die weitere Metallfolie an keiner der Querkanten und keiner der Längskanten der Rückseite des Keramiksubstrats über.

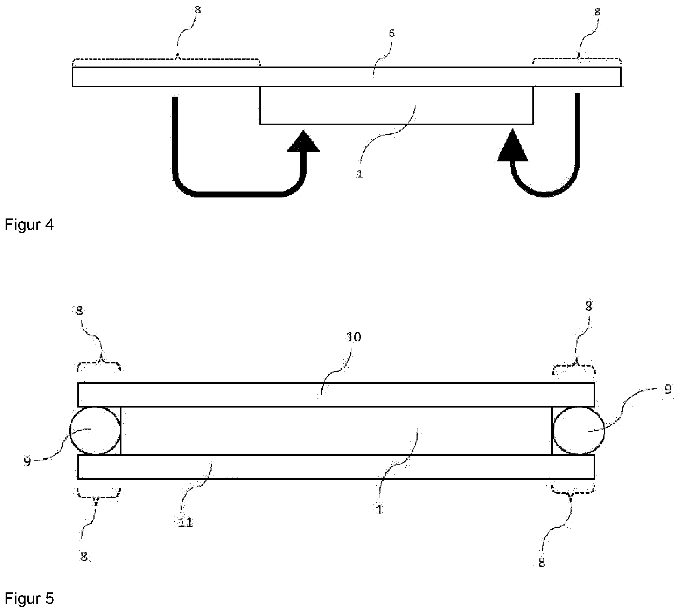

Figur 4 veranschaulicht das in Kontakt bringen der Vorderseite eines Keramiksubstrats 1 mit einer Metallfolie 6, die an den Längskanten der Vorderseite des Keramiksubstrats übersteht, und das in Kontakt bringen der metallischen Längskantenüberstände 8 mit der Rückseite des Keramiksubstrats 1. Durch die geschweiften gestrichelten Klammern werden die Abmessungen der metallischen Längskantenüberstände 8 veranschaulicht. Die Pfeile in Figur 4 veranschaulichen, wie die metallischen Längskantenüberstände 8 in Richtung der Rückseite des Keramiksubstrats gefaltet werden.

Das mit dem ersten erfindungsgemäßen Verfahren oder dem zweiten erfindungsgemäßen Verfahren hergestellte metallisierte Keramiksubstrat weist beispielsweise in einer Richtung parallel zu einer der Querkanten eine Länge L1 und in einer Richtung parallel zu einer der Längskanten eine Länge L2 auf, wobei das metallisierte Keramiksubstrat

in einem ersten Flächenabschnitt, der sich von $0 \times L1$ bis $1/3 \times L1$ und über die gesamte Länge L2 erstreckt, eine maximale Dicke d1 aufweist,
in einem zweiten Flächenabschnitt, der sich von $> 1/3 \times L1$ bis $2/3 \times L1$ und über die gesamte Länge L2 erstreckt, eine maximale Dicke d2 aufweist,
in einem dritten Flächenabschnitt, der sich von $> 2/3 \times L1$ bis $3/3 \times L1$ und über die gesamte Länge L2 erstreckt, eine maximale Dicke d3 aufweist,
wobei Folgendes gilt:
$0{,}9 \leq d2/d1 \leq 1{,}1$ und $0{,}9 \leq d2/d3 \leq 1{,}1$.

In dem ersten und zweiten erfindungsgemäßen Verfahren kann optional die Vorderseiten- oder Rückseitenmetallisierung in definierten Bereichen abgetragen werden, beispielsweise unter Berücksichtigung einer spezifischen Schaltungsstruktur, die auf dem metallisierten Keramiksubstrat angebracht werden soll.

In dem ersten erfindungsgemäßen Verfahren kann optional der stoffschlüssige Verbund der metallischen Längskantenüberstände oder der stoffschlüssige Verbund der metallischen Längskantenüberstände und des metallischen Verbindungskörpers in definierten Bereichen abgetragen werden.

Das Abtragen in definierten Bereichen erfolgt durch Abtragungsverfahren, die dem Fachmann bekannt sind, beispielsweise durch ein Ätzen (z.B. unter Verwendung einer Ätzmaske), ein Fräsen oder eine Laserablation.

Wie oben bereits erwähnt, kann das bereitgestellte Keramiksubstrat ein Mehrfachnutzen- oder ein Einfachnutzen-Keramiksubstrat sein. Hinsichtlich der Prozesseffizienz kann es vorteilhaft sein, ein Mehrfachnutzen-Keramiksubstrat zu verwenden und dieses nach seiner Metallisierung zu vereinzeln, d.h. in mehrere Einfachnutzen-Keramiksubstrate aufzutrennen.

In einer beispielhaften Ausführungsform ist das bereitgestellte Keramiksubstrat ein Mehrfachnutzen-Keramiksubstrat und das metallisierte Keramiksubstrat wird vor oder nach dem stoffschlüssigen Verbinden der sich gegenüberstehenden Längskantenüberstände vereinzelt, so dass zwei oder mehr (z.B. mindestens 4, bevorzugter mindestens 6) metallisierte Einfachnutzen-Keramiksubstrate erhalten werden.

Die Vereinzelung erfolgt beispielsweise durch ein Brechen entlang von Sollbruchstellen, die im Keramiksubstrat in bekannter Weise (z.B. durch mechanisches Ritzen oder eine Laserbehandlung) eingefügt werden.

In einer beispielhaften Ausführungsform des ersten oder zweiten erfindungsgemäßen Verfahrens wird die Vorderseiten- oder Rückseitenmetallisierung stoffschlüssig mit einem weiteren metallisierten Keramiksubstrat verbunden, so dass ein metallisiertes Keramikmehrfachsubstrat erhalten wird, das mindestens zwei Keramiksubstrate enthält. Sofern das weitere metallisierte Keramiksubstrat sowohl eine Vorderseiten- wie auch eine Rückseitenmetallisierung aufweist, sind diese bevorzugt elektrisch isoliert voneinander.

Die vorliegende Erfindung betrifft außerdem ein Verfahren zur Herstellung eines Halbleitermoduls, umfassend

die Herstellung eines metallisierten Keramiksubstrats nach dem ersten oder zweiten erfindungsgemäßen Verfahren und
das Aufbringen von Halbleiterbauelementen auf dem metallisierten Keramiksubstrat.

Weiterhin wird die Aufgabe gelöst durch ein erstes erfindungsgemäßes metallisiertes Keramiksubstrat, umfassend:

ein Keramiksubstrat, das eine Vorderseite, eine Rückseite und Seitenflächen, die die Vorder- und Rückseite miteinander verbinden, umfasst, wobei die Vorderseite und Rückseite jeweils zwei Längskanten und zwei Querkanten aufweisen,
eine Vorderseitenmetallisierung, die stoffschlüssig mit der Vorderseite des Keramiksubstrats verbunden ist und an jeder der Längskanten, jedoch keiner der Querkanten der Vorderseite des Keramiksubstrats übersteht, so dass an jeder der Längskanten der Vorderseite des Keramiksubstrats ein metallischer Längskantenüberstand, jedoch an keiner der Querkanten der Vorderseite des Keramiksubstrats ein metallischer Querkantenüberstand vorliegt, eine Rückseitenmetallisierung, die stoffschlüssig mit der Rückseite des Keramiksubstrats verbunden ist und an jeder der Längskanten, jedoch keiner der Querkanten der Rückseite des Keramiksubstrats übersteht, so dass an jeder der Längskanten der Rückseite des Keramiksubstrats ein metallischer Längskantenüberstand, jedoch an keiner der Querkanten der Rückseite des Keramiksubstrats ein metallischer Querkantenüberstand vorliegt, wobei die metallischen Längskantenüberstände der Vorderseite und der Rückseite des Keramiksubstrats stoffschlüssig miteinander oder mit einem oder mehreren metallischen Verbindungskörpern, die zwischen den metallischen Längskantenkantenüberständen positioniert sind, verbunden sind, so dass die Vorderseitenmetallisierung und Rückseitenmetallisierung des metallisierten Keramiksubstrats elektrisch leitend miteinander verbunden sind.

Da die Vorderseitenmetallisierung (d.h. die auf der Vorderseite des Keramiksubstrats vorliegende Metallbeschichtung) und die Rückseitenmetallisierung (d.h. die auf der Rückseite des Keramiksubstrats vorliegende Metallbeschichtung) elektrisch leitend miteinander verbunden sind, lassen sich unter Verwendung des erfindungsgemäßen metallisierten Keramiksubstrats Leistungsmodule fertigen, die eine sehr niedrige Induktivität aufweisen. Da außerdem die Längskantenüberstände miteinander oder mit einem oder mehreren zwischen den Längskantenüberständen positionierten metallischen Verbindungskörpern verbunden sind und somit die Verwendung eines an der Oberfläche der Metallisierungen hervorstehenden Verbindungskörpers wie z.B. eines aufgelöteten Metallbügels vermieden wird, kann eine Reduzierung der planaren Metalloberfläche vermieden werden. Dies ermöglicht eine gute und effiziente Verbindung des metallisierten Keramiksubstrats mit einer weiteren Metallschicht, über die wiederum die thermische Verbindung zum Kühlkörper hergestellt wird.

Alternativ wird die Aufgabe gelöst durch ein zweites erfindungsgemäßes metallisiertes Keramiksubstrat, umfassend:

ein Keramiksubstrat, das eine Vorderseite, eine Rückseite und Seitenflächen, die die Vorder- und Rückseite miteinander verbinden, umfasst, wobei die Vorderseite und Rückseite jeweils zwei Längskanten und zwei Querkanten aufweisen, eine Vorderseitenmetallisierung, die stoffschlüssig mit der Vorderseite des Keramiksubstrats verbunden ist und an jeder der Längskanten, jedoch keiner der Querkanten der Vorderseite des Keramiksubstrats übersteht, so dass an jeder der Längskanten der Vorderseite des Keramiksubstrats ein metallischer Längskantenüberstand, jedoch an keiner der Querkanten der Vorderseite des Keramiksubstrats ein metallischer Querkantenüberstand vorliegt, wobei die metallischen Längskantenüberstände der Vorderseite sich bis zur Rückseite des Keramiksubstrats erstrecken und stoffschlüssig mit der Rückseite des Keramiksubstrats verbunden sind, so dass eine Rückseitenmetallisierung vorliegt und die Vorderseitenmetallisierung und Rückseitenmetallisierung des metallisierten Keramiksubstrats elektrisch leitend miteinander verbunden sind.

Auch in dieser alternativen Ausführungsform sind die Vorderseitenmetallisierung (d.h. die auf der Vorderseite des Keramiksubstrats vorliegende Metallbeschichtung) und die Rückseitenmetallisierung (d.h. die auf der Rückseite des Keramiksubstrats vorliegende Metallbeschichtung) elektrisch leitend miteinander verbunden und ermöglichen so die Herstellung niederinduktiver Leistungsmodule. Die Längskantenüberstände der Vorderseite erstrecken sich bis zur Rückseite des Keramiksubstrats und sind stoffschlüssig mit der Rückseite des Keramiksubstrats verbunden, so dass die Verwendung eines an der Oberfläche der Metallisierungen hervorstehenden Verbindungskörpers wie z.B. eines aufgelöteten Metallbügels vermieden werden kann. Dies ermöglicht eine gute und effiziente Verbindung des metallisierten Keramiksubstrats mit einer weiteren Metallschicht, über die wiederum die thermische Verbindung zum Kühlkörper hergestellt wird.

In dem ersten und zweite erfindungsgemäßen metallisierten Keramiksubstrat sind die Vorderseitenmetallisierung und Rückseitenmetallisierung über zwei der Seitenflächen des Keramiksubstrats elektrisch leitend miteinander verbunden.

In einer beispielhaften Ausführungsform weisen das erste erfindungsgemäße metallisierte Keramiksubstrat und das zweite erfindungsgemäße metallisierte in einer Richtung parallel zu einer der Querkanten eine Länge L1 und in einer Richtung parallel zu einer der Längskanten eine Länge L2 auf, wobei das metallisierte Keramiksubstrat

in einem ersten Flächenabschnitt, der sich von $0 \times L1$ bis $1/3 \times L1$ und über die gesamte Länge L2 erstreckt, eine maximale Dicke d1 aufweist, in einem zweiten Flächenabschnitt, der sich von $> 1/3 \times L1$ bis $2/3 \times L1$ und über die gesamte Länge L2 erstreckt, eine maximale Dicke d2 aufweist, in einem dritten Flächenabschnitt, der sich von $> 2/3 \times L1$ bis $3/3 \times L1$ und über die gesamte Länge L2 erstreckt, eine maximale Dicke d3 aufweist, wobei Folgendes gilt:
$0,9 \leq d2/d1 \leq 1,1$ und $0,9 \leq d2/d3 < 1,1$.

Das Keramiksubstrat des ersten und zweiten erfindungsgemäßen metallisierten Keramiksubstrats enthält beispielsweise Aluminiumoxid, Aluminiumnitrid oder Siliziumnitrid. Beispielsweise enthält das Keramiksubstrat Aluminiumoxid, Aluminiumnitrid oder Siliziumnitrid in einem Anteil von mindestens 70 Gew%. Beispielsweise enthält das Keramiksubstrat neben Aluminiumoxid noch ein Zirkonoxid, z.B. in einem Anteil von bis zu 30 Gew% (beispielsweise 1-30 Gew%). Das Zirkonoxid ist beispielsweise ein mit Yttrium, Magnesium und/oder Kalzium dotiertes Zirkonoxid.

Das Keramiksubstrat weist beispielsweise eine Dicke im Bereich von 0,1 mm bis 1,0 mm auf.

Wie oben erwähnt, kann das Keramiksubstrat ein Mehrfachnutzen-Keramiksubstrat oder ein Einfachnutzen-Keramiksubstrat sein.

Die beiden Längskanten der Vorderseite verlaufen bevorzugt im Wesentlichen parallel zueinander (180° +/- 10°). Die Längs- und Querkanten verlaufen beispielsweise im Wesentlichen senkrecht zueinander (90° +/- 10°). Die Längs- und Querkanten der Vorderseite treffen sich in den Ecken, wobei es sich bei den Ecken auch um abgeschrägte oder abgerundete Ecken handeln kann. Auch für die Rückseite des Keramiksubstrats gilt, dass die beiden Längskanten bevorzugt im Wesentlichen parallel zueinander (180° +/- 10°) verlaufen und/oder die Längs- und Querkanten bevorzugt im Wesentlichen senkrecht zueinander (90° +/-10°) verlaufen.

Die Vorderseiten- und Rückseitenmetallisierung des ersten und zweiten erfindungsgemäßen metallisierten Keramiksubstrats enthalten beispielsweise Kupfer (z.B. in einem Anteil von mindestens 97 Gew%) oder Aluminium (z.B. in einem Anteil von mindestens 97 Gew%).

Die Vorderseiten- und Rückseitenmetallisierung weisen beispielsweise eine maximale Dicke ≤ 1,5 mm, z.B. im Bereich von 0,05 mm bis 1,5 mm, bevorzugter 0,2 mm bis 0,6 mm auf.

Die Vorderseiten- oder Rückseitenmetallisierung kann optional strukturiert sein, z.B. in Form einer bestimmten Schaltungsstruktur. Eine strukturierte Vorderseitenmetallisierung oder Rückseitenmetallisierung umfasst zwei oder mehr Metallisierungsbereiche, die durch Aussparungen voneinander getrennt sind. Wie oben bereits erwähnt, werden diese Aussparungen durch geeignete Abtragungsverfahren wie Ätzen oder Laserablation erzeugt.

In dem ersten erfindungsgemäßen metallisierten Keramiksubstrat stehen beispielsweise die Längskantenüberstände der Vorderseiten- und Rückseitenmetallisierung jeweils um nicht mehr als 5 mm, bevorzugter nicht mehr als 3 mm an den Längskanten über. Die Länge eines Längskantenüberstands wird bestimmt in einer Richtung senkrecht zur Längskante.

In dem ersten erfindungsgemäßen metallisierten Keramiksubstrat kann beispielsweise zumindest einer der metallischen Längskantenüberstände, der mit einem weiteren metallischen Längskantenüberstand stoffschlüssig verbunden ist, zumindest einmal entlang einer Faltkante gefaltet sein. Die Faltkante verläuft beispielsweise im Wesentlichen parallel (180° +/- 10°) zu der Längskante, an der der gefaltete metallische Längskantenüberstand übersteht.

In dem ersten erfindungsgemäßen metallisierten Keramiksubstrat ist der mindestens eine metallische Verbindungskörper, mit dem die Längskantenüberstände der Vorderseite und Rückseite verbunden sind, beispielsweise drahtförmig oder bandförmig.

Beispielsweise enthält der metallische Verbindungskörper Kupfer oder Aluminium. Bevorzugt enthält der metallische Verbindungskörper mindestens 97 Gew% Kupfer oder mindestens 97 Gew% Aluminium. In einer beispielhaften Ausführungsform ist der metallische Verbindungskörper ein Kupferdraht, ein Kupferbändchen, ein Aluminiumdraht oder ein Aluminiumbändchen.

Ist der metallische Verbindungskörper drahtförmig (z.B. ein Kupfer- oder Aluminiumdraht), so weist der Draht bevorzugt eine Dicke auf, die nicht größer ist als die Dicke des Keramiksubstrats. Ist der metallische Verbindungskörper bandförmig (z.B. ein Kupfer- oder Aluminiumbändchen), so weist das Band bevorzugt eine Bandbreite oder eine Banddicke auf, die nicht größer ist als die Dicke des Keramiksubstrats.

Beispielsweise ist der draht- oder bandförmige metallische Verbindungskörper zumindest abschnittsweise im Wesentlichen parallel (180° +/- 10°) zu einer der Seitenflächen des Keramiksubstrats positioniert.

Optional ist zumindest einer der metallischen Längskantenüberstände und/oder zumindest einer der metallischen Verbindungskörper in Kontakt und/oder stoffschlüssig verbunden mit einer der Seitenflächen des Keramiksubstrats.

Beispielsweise ist das metallisierte Keramiksubstrat ein metallisiertes Keramikmehrfachsubstrat, das mindestens zwei Keramiksubstrate enthält. Beispielsweise ist die Vorderseiten- oder Rückseitenmetallisierung des ersten metallisierten Keramiksubstrats (d.h. des Keramiksubstrats, dessen Vorderseiten- und Rückseitenmetallisierung elektrisch leitend miteinander verbunden sind) stoffschlüssig mit einem weiteren metallisierten Keramiksubstrat verbunden. Sofern das weitere metallisierte Keramiksubstrat sowohl eine Vorderseiten- wie auch eine Rückseitenmetallisierung aufweist, sind diese bevorzugt elektrisch isoliert voneinander.

Eine beispielhafte Ausführungsform des ersten erfindungsgemäßen metallisierten Keramiksubstrats wird in Figur 5 veranschaulicht. Auf dem Keramiksubstrat 1 liegen eine Vorderseitenmetallisierung 10 und eine Rückseitenmetallisierung 11 vor, die jeweils an den Längskanten des Keramiksubstrats 1 überstehen. An den Längskanten der Vorderseite und der Rückseite des Keramiksubstrats 1 liegen somit metallische Längskantenüberstände 8 vor. Durch die geschweiften gestrichelten Klammern werden die Abmessungen der metallischen Längskantenüberstände 8 veranschaulicht. Die Längskantenüberstände 8 der Vorderseite und der Rückseite des Keramiksubstrats 1 und die zwischen diesen Längskantenüberständen 8 positionierten drahtförmigen metallischen Verbindungskörper 9 sind stoffschlüssig verbunden.

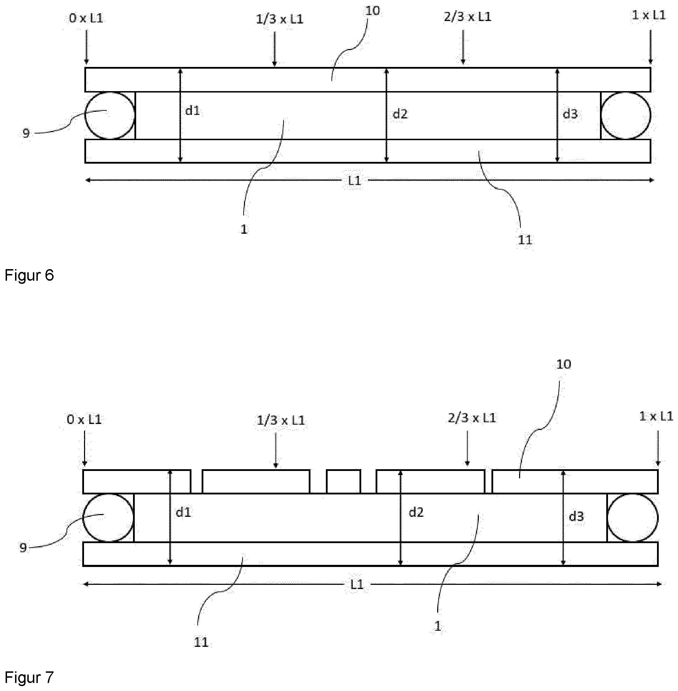

Figur 6 zeigt eine beispielhafte Ausführungsform des ersten erfindungsgemäßen metallisierten Keramiksubstrats, die die folgende Beziehung erfüllt: $0,9 \leq d2/d1 \leq 1,1$ und $0,9 \leq d2/d3 \leq 1,1$.

In einer Richtung parallel zu den Querkanten des Keramiksubstrats 1 weist das metallisierte Keramiksubstrat eine Länge L1 auf. Auf dem Keramiksubstrat 1 liegen eine Vorderseitenmetallisierung 10 und eine Rückseitenmetallisierung 11 vor. Die metallischen Längskantenüberstände sind mit den metallischen Verbindungskörpern 9 stoffschlüssig verbunden. Da die metallischen Verbindungskörper 9 zwischen den metallischen Längskantenüberständen der Vorderseite und Rückseite des Keramiksubstrats 1 positioniert sind, wird eine Zunahme der Dicke der Metallisierungen vermieden. Die oben genannte Beziehung zwischen den maximalen Dicken d1, d2 und d3 des metallisierten Keramiksubstrats in den drei Flächenabschnitten (d.h. von 0 x L1 bis 1/3 x L1; von > 1/3 x L1 bis 2/3 x L1 und von > 2/3 x L1 bis 3/3 x L1) ist erfüllt, d.h. $0,9 \leq d2/d1 \leq 1,1$ und $0,9 \leq d2/d3 \leq 1,1$.

Eine weitere beispielhafte Ausführungsform des erfindungsgemäßen metallisierten Keramiksubstrats wird in Figur 7 veranschaulicht. Diese unterscheidet sich von der in Figur 6 veranschaulichten Ausführungsform lediglich dadurch, dass die Vorderseitenmetallisierung 10 des Keramiksubstrats 1 durch eine Ätzbehandlung strukturiert wurde und daher Aussparungen aufweist. Die oben genannte Beziehung zwischen den maximalen Dicken d1, d2 und d3 des metallisierten Keramiksubstrats in den drei Flächenabschnitten (d.h. von 0 x L1 bis 1/3 x L1; von > 1/3 x L1 bis 2/3 x L1 und von > 2/3 x L1 bis 3/3 x L1) ist erfüllt, d.h. $0,9 \leq d2/d1 \leq 1,1$ und $0,9 \leq d2/d3 \leq 1,1$.

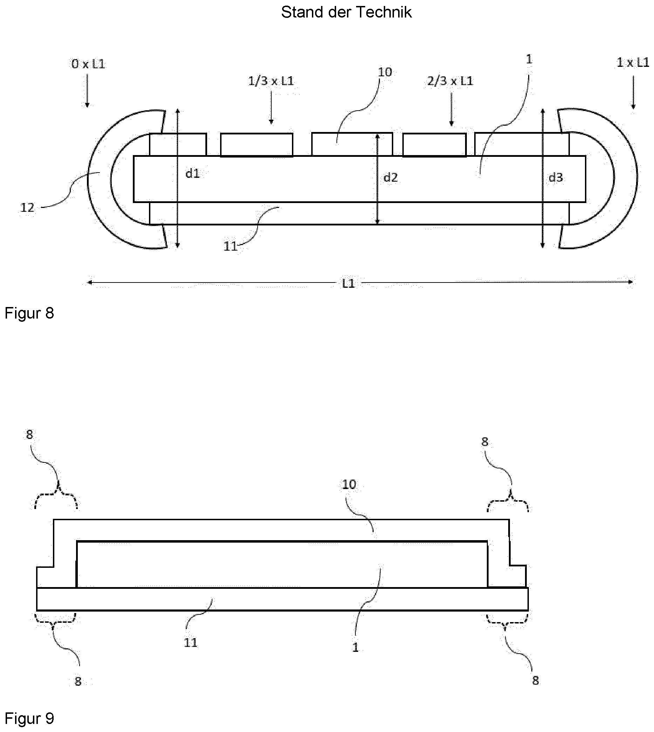

Figur 8 veranschaulicht die aus dem Stand der Technik bekannte Verbindung der Vorderseitenmetallisierung und Rückseitenmetallisierung des Keramiksubstrats über einen Metallbügel. In einer Richtung parallel zu den Querkanten des Keramiksubstrats 1 weist das metallisierte Keramiksubstrat eine Länge L1 auf. Auf dem Keramiksubstrat 1 liegen eine Vorderseitenmetallisierung 10 und eine Rückseitenmetallisierung 11 vor, die über einen augelöteten Metallbügel 12 miteinander verbunden sind. Durch die Metallbügel kommt es in den Endabschnitten des metallisierten Keramiksubstrats zu einer deutlichen Zunahme der Dicke der Metallisierungen. Die oben genannte Beziehung zwischen den maximalen Dicken d1, d2 und d3 des metallisierten Keramiksubstrats in den drei Flächenabschnitten (d.h. von 0 x L1 bis 1/3 x L1; von > 1/3 x L1 bis 2/3 x L1 und von > 2/3 x L1 bis 3/3 x L1) ist nicht erfüllt.

Figur 9 veranschaulicht eine beispielhafte Ausführungsform des ersten erfindungsgemäßen metallisierten Keramiksubstrats. Auf dem Keramiksubstrat 1 liegen eine Vorderseitenmetallisierung 10 und eine Rückseitenmetallisierung 11 vor, die an den Längskanten des Keramiksubstrats 1 überstehen. Die metallischen Längskantenüberstände 8 der Vorder- und Rückseite des Keramiksubstrats 1 sind stoffschlüssig miteinander verbunden. Durch die geschweiften gestrichelten Klammern sind die Abmessungen der Längskantenüberstände 8 angedeutet. Die Längskantenüberstände 8 der Vorderseite des Keramiksubstrats 1 wurden zweimal um etwa 90° gefaltet und dadurch mit den Längskantenüberständen 8 der Rückseite des Keramiksubstrats 1 in Kontakt gebracht. Für das in Kontakt bringen der Längskantenüberstände wäre auch eine einmalige Faltung, beispielsweise um etwa 90°, ausreichend.

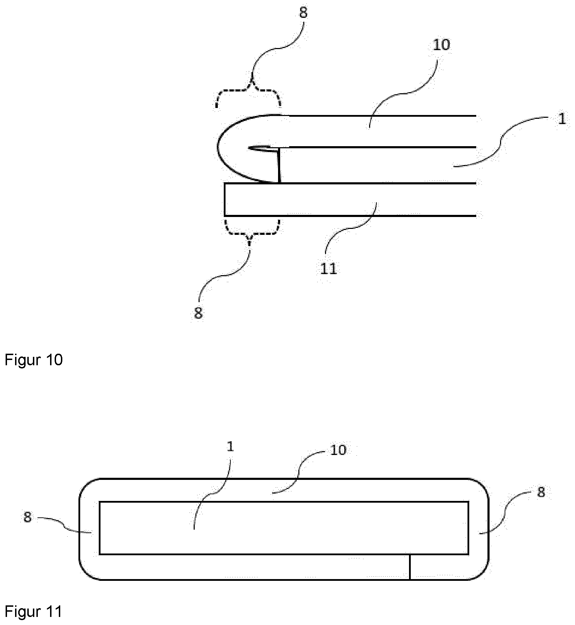

Figur 10 veranschaulicht eine beispielhafte Ausführungsform des ersten erfindungsgemäßen metallisierten Keramiksubstrats. Auf dem Keramiksubstrat 1 liegen eine Vorderseitenmetallisierung 10 und eine Rückseitenmetallisierung 11 vor, die an den Längskanten des Keramiksubstrats 1 überstehen. Die metallischen Längskantenüberstände 8 der Vorder- und Rückseite des Keramiksubstrats 1 sind stoffschlüssig miteinander verbunden. Durch die geschweiften gestrichelten Klammern sind die Abmessungen der Längskantenüberstände 8 angedeutet. Der Längskantenüberstand 8 der Vorderseite des Keramiksubstrats 1 wurden um etwa 180° gefaltet und dadurch mit dem Längskantenüberstand 8 der Rückseite des Keramiksubstrats 1 in Kontakt gebracht.

Figur 11 veranschaulicht eine beispielhafte Ausführungsform des zweiten erfindungsgemäßen metallisierten Keramiksubstrats. Auf der Vorderseite des Keramiksubstrats 1 liegt eine Vorderseitenmetallisierung 10 vor. Die Längskantenüberstände 8 der Vorderseite erstrecken sich bis zur Rückseite des Keramiksubstrats 1 und bilden dort die Rückseitenmetallisierung aus.

Das erste erfindungsgemäße metallisierte Keramiksubstrat ist beispielsweise durch das erste erfindungsgemäße Verfahren erhältlich.

Das zweite erfindungsgemäße metallisierte Keramiksubstrat ist beispielsweise durch das zweite erfindungsgemäße Verfahren erhältlich.

Weiterhin betrifft die vorliegende Erfindung ein Halbleitermodul, enthaltend

    das erste oder zweite erfindungsgemäße metallisierte Keramiksubstrat,
    ein oder mehrere Halbleiterbauelemente.

Die Halbleiterbauelemente sind beispielsweise auf dem metallisierten Keramiksubstrat angebracht.

Weiterhin betrifft die vorliegende Erfindung die Verwendung des ersten oder zweiten erfindungsgemäßen metallisierten Keramiksubstrats als Leiterplatte, insbesondere in der Leistungselektronik.

Auf Basis der Maxwell-Gleichungen und daraus abgeleiteter Gleichungen wurde für ein Halbleitermodul, das das erste erfindungsgemäße metallisierte Keramiksubstrat und darauf angebrachte Halbleiterelemente enthält, die Streuinduktivität berechnet. Für die Berechnung wurde beispielhaft von einem Keramiksubstrat mit folgenden Abmessungen ausgegangen: 0,38 mm (Dicke) x 60 mm x 40 mm. Es ergab sich eine sehr niedrige Streuinduktivität von lediglich 2 nH.

Auch für ein Halbleitermodul, das das zweite erfindungsgemäße metallisierte Keramiksubstrat und darauf angebrachte Halbleiterelemente enthält, wurde auf Basis der Maxwell-Gleichungen und daraus abgeleiteter Gleichungen die Streuinduktivität berechnet. Wiederum wurde für die Berechnung von einem Keramiksubstrat mit folgenden Abmessungen ausgegangen: 0,38 mm (Dicke) x 60 mm x 40 mm. Wie bereits für das erste erfindungsgemäße metallisierte Keramiksubstrat ergab sich auch für das zweite erfindungsgemäße metallisierte Keramiksubstrat eine sehr niedrige Streuinduktivität von etwa 2 nH.

Liste der Bezugszeichen:

1 Keramiksubstrat
2 Vorderseite des Keramiksubstrats
3 Seitenflächen des Keramiksubstrats
4 Längskanten der Vorder- und Rückseite des Keramiksubstrats
5 Querkanten der Vorder- und Rückseite des Keramiksubstrats
6 erste Metallfolie
7 zweite Metallfolie
8 metallische Längskantenüberstände
9 metallischer Verbindungskörper
10 Vorderseitenmetallisierung
11 Rückseitenmetallisierung

**Patentansprüche**

1. Ein Verfahren zur Herstellung eines metallisierten Keramiksubstrats, das eine Vorderseitenmetallisierung (10) und eine Rückseitenmetallisierung (11) aufweist, die elektrisch leitend miteinander verbunden sind, wobei das Verfahren folgende Schritte umfasst:

Bereitstellung eines Keramiksubstrats (1), das eine Vorderseite (2), eine Rückseite und Seitenflächen (3), die die Vorderseite (2) und Rückseite miteinander verbinden, umfasst, wobei die Vorderseite (2) und die Rückseite jeweils zwei Längskanten (4) und zwei Querkanten (5) aufweisen,
in Kontakt bringen der Vorderseite (2) des Keramiksubstrats mit einer ersten Metallfolie (6), wobei die erste Metallfolie (6) an jeder der Längskanten (4) der Vorderseite (2) des Keramiksubstrats übersteht, so dass an jeder der Längskanten (4) der Vorderseite (2) des Keramiksubstrats ein metallischer Längskantenüberstand (8) vorliegt,
in Kontakt bringen der Rückseite des Keramiksubstrats mit einer zweiten Metallfolie (7), wobei die zweite Metallfolie (7) an jeder der Längskanten (4) der Rückseite des Keramiksubstrats übersteht, so dass an jeder der Längskanten (4) der Rückseite des Keramiksubstrats ein metallischer Längskantenüberstand (8) vorliegt,
wobei an zwei der Seitenflächen (3) des Keramiksubstrats sich die metallischen Längskantenüberstände (8) der Vorderseite (2) und der Rückseite des Keramiksubstrats gegenüberstehen,
stoffschlüssiges Verbinden der Vorderseite (2) des Keramiksubstrats mit der ersten Metallfolie (6), so dass eine Vorderseitenmetallisierung (10) erhalten wird,
stoffschlüssiges Verbinden der Rückseite des Keramiksubstrats mit der zweiten Metallfolie (7), so dass eine Rückseitenmetallisierung (11) erhalten wird,
stoffschlüssiges Verbinden der sich gegenüberstehenden metallischen Längskantenüberstände (8) miteinander oder mit einem oder mehreren metallischen Verbindungskörpern (9), die zwischen den sich gegenüberstehenden metallischen Längskantenkantenüberständen (8) positioniert sind, so dass ein metallisiertes Keramiksubstrat erhalten wird, dessen Vorderseitenmetallisierung (10) und Rückseitenmetallisierung (11) über zwei Seitenflächen (3) des Keramiksubstrats elektrisch leitend miteinander verbunden sind.

2. Das Verfahren nach Anspruch 1, wobei die erste Metallfolie (6) und die zweite Metallfolie (7) jeweils eine Kupfer- oder Aluminiumfolie ist.

3. Das Verfahren nach Anspruch 1 oder 2, wobei die erste Metallfolie (6) an keiner der Querkanten (5) der Vorderseite (3) des Keramiksubstrats übersteht und/oder die zweite Metallfolie (7) an keiner der Querkanten (5) der Rückseite des Keramiksubstrats übersteht.

4. Das Verfahren nach einem der vorstehenden Ansprüche, wobei das stoffschlüssige Verbinden der ersten Metallfolie (6) mit der Vorderseite (2) des Keramiksubstrats und das stoffschlüssige Verbinden der zweiten Metallfolie (7) mit der Rückseite des Keramiksubstrats durch ein eutektisches Bonden, insbesondere ein Direct-Copper-Bonding (DCB), oder ein Löten, insbesondere ein Aktivlöten, erfolgt.

5. Das Verfahren nach einem der vorstehenden Ansprüche, wobei das stoffschlüssige Verbinden der sich gegenüberstehenden Längskantenüberstände (8) miteinander oder mit einem oder mehreren metallischen Verbindungskörpern (9) durch ein Löten, ein Sintern, ein Kleben unter Verwendung eines elektrisch leitfähigen Klebstoffs, ein eutektisches Bonden, insbesondere ein Direct-Copper-Bonding (DCB), oder ein mechanischer Verfahren erfolgt.

6. Das Verfahren nach einem der vorstehenden Ansprüche, wobei der metallische Verbindungskörper (9), mit dem die sich gegenüberstehenden Längskantenüberstände (8) stoffschlüssig verbunden werden, drahtförmig oder bandförmig ist; und/oder wobei der metallische Verbindungskörper (9) Kupfer oder Aluminium enthält.

7. Das Verfahren nach Anspruch 6, wobei der drahtförmige metallische Verbindungskörper (9) eine Dicke aufweist, die nicht größer ist als die Dicke des Keramiksubstrats (1) oder der bandförmige metallische Verbindungskörper (9) eine Dicke und/oder Breite aufweist, die nicht größer ist als die Dicke des Keramiksubstrats (1).

8. Ein Verfahren zur Herstellung eines metallisierten Keramiksubstrats, das eine Vorderseitenmetallisierung (10) und eine Rückseitenmetallisierung (11) aufweist, die elektrisch leitend miteinander verbunden sind, wobei das Verfahren folgende Schritte umfasst:

   Bereitstellung eines Keramiksubstrats (1), das eine Vorderseite (2), eine Rückseite und Seitenflächen (3), die die Vorderseite (2) und Rückseite miteinander verbinden, umfasst, wobei die Vorderseite (2) und die Rückseite jeweils zwei Längskanten (4) und zwei Querkanten (5) aufweisen,
   in Kontakt bringen der Vorderseite (2) des Keramiksubstrats mit einer Metallfolie (6), wobei die Metallfolie (6) an jeder der Längskanten (4) der Vorderseite des Keramiksubstrats übersteht, so dass an jeder der Längskanten (4) der Vorderseite des Keramiksubstrats ein metallischer Längskantenüberstand (8) vorliegt und wobei sich die metallischen Längskantenüberstände (8) bis zur Rückseite des Keramiksubstrats erstrecken, so dass die Metallfolie (6) auch mit der Rückseite des Keramiksubstrats in Kontakt ist,
   stoffschlüssiges Verbinden der Metallfolie (6) mit der Vorderseite (2) und Rückseite des Keramiksubstrats unter Ausbildung einer Vorderseitenmetallisierung (10) und Rückseitenmetallisierung (11), so dass ein metallisiertes Keramiksubstrat erhalten wird, dessen Vorderseitenmetallisierung (10) und Rückseitenmetallisierung (11) über zwei Seitenflächen (3) des Keramiksubstrats elektrisch leitend miteinander verbunden sind.

9. Das Verfahren nach Anspruch 8, wobei die Metallfolie (6) eine Kupfer- oder Aluminiumfolie ist und/oder das stoffschlüssige Verbinden der Metallfolie (6) mit der Vorderseite (2) und Rückseite des Keramiksubstrats durch ein eutektisches Bonden, insbesondere ein Direct-Copper-Bonding (DCB), oder ein Löten, insbesondere ein Aktivlöten, erfolgt

10. Das Verfahren nach Anspruch 8 oder 9, wobei die Metallfolie (6) an keiner der Querkanten (5) der Vorderseite des Keramiksubstrats übersteht.

11. Das Verfahren nach einem der vorstehenden Ansprüche, wobei das Keramiksubstrat (1) Aluminiumoxid, Aluminiumnitrid oder Siliziumnitrid enthält.

12. Das Verfahren nach einem der vorstehenden Ansprüche, wobei die Vorderseitenmetallisierung (10) oder Rückseitenmetallisierung (11) in definierten Bereichen abgetragen wird.

13. Das Verfahren nach einem der vorstehenden Ansprüche, wobei die Vorderseitenmetallisierung (10) oder Rückseitenmetallisierung (11) stoffschlüssig mit einem weiteren metallisierten Keramiksubstrat verbunden wird, so dass ein metallisiertes Keramikmehrfachsubstrat erhalten wird, das mindestens zwei Keramiksubstrate enthält.

14. Ein Verfahren zur Herstellung eines Halbleitermoduls, umfassend Herstellung des metallisierten Keramiksubstrats nach einem der Ansprüche 1 bis 13, Aufbringen von Halbleiterbauelementen auf dem metallisierten Keramiksubstrat.

15. Ein metallisiertes Keramiksubstrat, umfassend:

   ein Keramiksubstrat (1), das eine Vorderseite (2), eine Rückseite und Seitenflächen (3), die die Vorderseite (2) und Rückseite miteinander verbinden, umfasst, wobei die Vorderseite (2) und Rückseite jeweils zwei Längskanten (4) und zwei Querkanten (5) aufweisen,
   eine Vorderseitenmetallisierung (10), die stoffschlüssig mit der Vorderseite (2) des Keramiksubstrats verbunden ist und an jeder der Längskanten (4), jedoch keiner der Querkanten (5) der Vorderseite (2) des Keramiksubstrats übersteht, so dass an jeder der Längskanten (4) der Vorderseite (2) des Keramiksubstrats ein metallischer Längskantenüberstand (8) vorliegt,
   eine Rückseitenmetallisierung (11), die stoffschlüssig mit der Rückseite des Keramiksubstrats verbunden ist und an jeder der Längskanten (4), jedoch keiner der Querkanten (5) der Rückseite des Keramiksubstrats übersteht, so dass an jeder der Längskanten (4) der Rückseite des Keramiksubstrats ein metallischer Längskantenüberstand (8) vorliegt,

wobei die metallischen Längskantenüberstände (8) der Vorderseite (2) und der Rückseite des Keramiksubstrats stoffschlüssig miteinander oder mit einem oder mehreren metallischen Verbindungskörpern (9), die zwischen den metallischen Längskantenkantenüberständen (8) positioniert sind, verbunden sind, so dass die Vorderseitenmetallisierung (10) und Rückseitenmetallisierung (11) des metallisierten Keramiksubstrats elektrisch leitend miteinander verbunden sind.

16. Ein metallisiertes Keramiksubstrat, umfassend:

ein Keramiksubstrat (1), das eine Vorderseite (2), eine Rückseite und Seitenflächen (3), die die Vorderseite (2) und Rückseite miteinander verbinden, umfasst, wobei die Vorderseite (2) und Rückseite jeweils zwei Längskanten (4) und zwei Querkanten (5) aufweisen, eine Vorderseitenmetallisierung (10), die stoffschlüssig mit der Vorderseite (2) des Keramiksubstrats verbunden ist und an jeder der Längskanten (5), jedoch keiner der Querkanten (5) der Vorderseite (2) des Keramiksubstrats übersteht, so dass an jeder der Längskanten (5) der Vorderseite (2) des Keramiksubstrats ein metallischer Längskantenüberstand (8) vorliegt, wobei die metallischen Längskantenüberstände (8) der Vorderseite (2) sich bis zur Rückseite des Keramiksubstrats erstrecken und stoffschlüssig mit der Rückseite des Keramiksubstrats verbunden sind, so dass eine Rückseitenmetallisierung (11) vorliegt und die Vorderseitenmetallisierung (10) und Rückseitenmetallisierung (11) des metallisierten Keramiksubstrats elektrisch leitend miteinander verbunden sind.

17. Das metallisierte Keramiksubstrat nach Anspruch 15 oder 16, in Richtung parallel zu einer der Querkanten (5) eine Länge L1 aufweisend und in Richtung parallel zu einer der Längskanten (4) eine Länge L2 aufweisend, wobei das metallisierte Keramiksubstrat

in einem ersten Flächenabschnitt, der sich von 0 x L1 bis 1/3 x L1 und über die gesamte Länge L2 erstreckt, eine maximale Dicke d1 aufweist, in einem zweiten Flächenabschnitt, der sich von > 1/3 x L1 bis 2/3 x L1 und über die gesamte Länge L2 erstreckt, eine maximale Dicke d2 aufweist, in einem dritten Flächenabschnitt, der sich von > 2/3 x L1 bis 3/3 x L1 und über die gesamte Länge L2 erstreckt, eine maximale Dicke d3 aufweist, wobei Folgendes gilt:

$0,9 \leq d2/d1 \leq 1,1$ und $0,9 \leq d2/d3 < 1,1$.

18. Das metallisierte Keramiksubstrat nach einem der Ansprüche 15 bis 17, wobei

das Keramiksubstrat (1) Aluminiumoxid, Aluminiumnitrid oder Siliziumnitrid enthält, die Vorderseitenmetallisierung (10) und Rückseitenmetallisierung (11) Kupfer oder Aluminium enthalten, der metallische Verbindungskörper (9), sofern anwesend, draht- oder bandförmig ist und/oder Kupfer oder Aluminium enthält.

19. Ein Halbleitermodul, enthaltend

ein metallisiertes Keramiksubstrat nach einem der Ansprüche 15 bis 18 und ein oder mehrere Halbleiterbauelemente.

20. Verwendung des metallisierten Keramiksubstrats nach einem der Ansprüche 15 bis 18 als Leiterplatte.

Figur 1a

Figur 1b

Figur 2

Figur 3

Figur 4

Figur 5

0 x L1  1/3 x L1  10  2/3 x L1  1 x L1

d1  d2  d3

9

L1

1  11

Figur 6

10

0 x L1  1/3 x L1  2/3 x L1  1 x L1

d1  d2  d3

9

L1

1

11

Figur 7

Stand der Technik

Figur 8

Figur 9

Figur 10

Figur 11

**EP 4 530 277 A1**

Europäisches
Patentamt

European
Patent Office

Office européen
des brevets

## EUROPÄISCHER RECHERCHENBERICHT

Nummer der Anmeldung

EP 23 19 9663

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,D | DE 10 2013 113734 A1 (ROGERS GERMANY GMBH [DE]) 11. Juni 2015 (2015-06-11) | 1,2,4,5, 11,12, 14,15, 17-20 | INV. C04B37/02 H01L23/373 H05K1/03 |
| Y | * Absätze [0002], [0040], [0070]; Anspruch 1; Abbildungen 2,3 * ----- | 1-20 | |
| Y | DE 10 2020 120189 A1 (ROGERS GERMANY GMBH [DE]) 3. Februar 2022 (2022-02-03) * Abbildung 1 * ----- | 1-20 | |
| A,D | J. F. BURGESS ET AL: "The Direct Bonding of Metals to Ceramics and Application in Electronics", ELECTROCOMPONENT SCIENCE AND TECHNOLOGY, Bd. 2, Nr. 4, 1. Januar 1976 (1976-01-01), Seiten 233-240, XP055264988, ISSN: 0305-3091, DOI: 10.1155/APEC.2.233 * Abbildungen 4,5 * ----- | 1-20 | |

**RECHERCHIERTE SACHGEBIETE (IPC)**

C04B
H01L
H05K

Der vorliegende Recherchenbericht wurde für alle Patentansprüche erstellt

| Recherchenort | Abschlußdatum der Recherche | Prüfer |
|---|---|---|
| Den Haag | 14. März 2024 | Raming, Tomas |

EPO FORM 1503 03.82 (P04C03)

**EP 4 530 277 A1**

## ANHANG ZUM EUROPÄISCHEN RECHERCHENBERICHT
## ÜBER DIE EUROPÄISCHE PATENTANMELDUNG NR.

EP 23 19 9663

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-03-2024

| Im Recherchenbericht angeführtes Patentdokument | Datum der Veröffentlichung | Mitglied(er) der Patentfamilie | Datum der Veröffentlichung |
|---|---|---|---|
| DE 102013113734 A1 | 11-06-2015 | CN 105900222 A | 24-08-2016 |
| | | DE 102013113734 A1 | 11-06-2015 |
| | | EP 3080055 A1 | 19-10-2016 |
| | | JP 6676528 B2 | 08-04-2020 |
| | | JP 2017501883 A | 19-01-2017 |
| | | KR 20160122700 A | 24-10-2016 |
| | | US 2016304405 A1 | 20-10-2016 |
| | | WO 2015085991 A1 | 18-06-2015 |
| DE 102020120189 A1 | 03-02-2022 | CN 115884953 A | 31-03-2023 |
| | | DE 102020120189 A1 | 03-02-2022 |
| | | EP 4168376 A1 | 26-04-2023 |
| | | JP 2023539423 A | 14-09-2023 |
| | | KR 20230025477 A | 21-02-2023 |
| | | US 2023286872 A1 | 14-09-2023 |
| | | WO 2022023544 A1 | 03-02-2022 |

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2017194200 A1
- US 2018286745 A1
- DE 102013113734 A1
- US 3744120 A
- DE 2319854

**In der Beschreibung aufgeführte Nicht-Patentliteratur**

- Streuinduktivität, ein Problem der Leistungselektronik. **R. BAYERER**. Bauelemente der Leistungselektronik und ihre Anwendungen. ETG-Fachtagung, 2017, 7
- **H.MA et al.** Review of the designs in low inductance SiC half-bridge packaging. *IET Power Electron.*, 2022, vol. 15, 989-1003
- **B. MOUAWAD** ; **J. LI** ; **A. CASTELLAZZI** ; **C. M. JOHNSON** ; **T. ERLBACHER** ; **P. FRIEDRICHS**. Low inductance 2.5 kV packaging technology for SiC switches. *CIPS 2016; 9th International Conference on Integrated Power Electronics Systems*, 2016, 1-6
- **B. MOUAWAD** ; **J. LI** ; **A. CASTELLAZZI** ; **P. FRIEDRICHS** ; **C. M. JOHNSON**. Low parasitic inductance multi-chip SiC devices packaging technology. *European Conference on Power Electronics and Applications (EPE'16 ECCE Europe)*, 2016
- **B. MOUAWAD** ; **J. LI** ; **A. CASTELLAZZI** ; **C. M. JOHNSON**. On the reliability of stacked metallized ceramic substrates under thermal cycling. *CIPS 2018; 10th International Conference on Integrated Power Electronics Systems*, 2018, 1-6
- **C. MARCZOK** ; **A. MEYER**. Direct Cooled Low Inductive SiC Mold Module. *Power Electronics Europe*, 2019, vol. 3, 19-20
- **T. HUBER** ; **A. KLEIMAIER**. Novel SiC Module Design - Optimised for Low Switching Losses, Efficient Cooling Path and Low Inductance. *IPS 2018; 10th International Conference on Integrated Power Electronics Systems*, 2018, 1-6
- **J.F. BURGESS et al.** The direct bonding of metals to ceramics and application in electronics. *Electrocomponent Science and Technology*, 1976, vol. 2, 233-240